# EUROPÄISCHE PATENTSCHRIFT

(11) **EP 2 211 147 B1**
(45) Veröffentlichungstag und Bekanntmachung des Hinweises auf die Patenterteilung: **28.11.2012**
(21) Anmeldenummer: 09000937.4
(22) Anmeldetag: 23.01.2009
(51) Int. Cl.: G01D 3/08, G01R 31/02, G01D 18/00

(54) **Verfahren zur Funktionsüberprüfung einer elektrischen Schaltung**
Method for testing the functionality of an electrical circuit
Procédé de contrôle du fonctionnement d'une circuit électrique

(43) Veröffentlichungstag der Anmeldung: 28.07.2010
(73) Patentinhaber: Micronas GmbH, 79108 Freiburg i. Br. (DE)
(72) Erfinder: Fink, Hans-Jörg, Dipl.-Ing., 79108 Freiburg (DE); Ring, Andreas, Dipl.-Ing. (FH), 79111 Freiburg (DE)
(74) Vertreter: Koch Müller Patentanwaltsgesellschaft mbH

(56) Entgegenhaltungen:
- EP-A- 1 970 720
- WO-A-2006/106111
- DE-A1- 10 037 495
- DE-A1-102007 019 183
- US-A1- 2008 162 080
- RAAB H: "AUSFALLINFORMATION BEI DIGITALEN MESSUMFORMERN MIT ANALOGEN AUSGANGSSIGNAL: VEREINHEITLICHUNG DES SIGNALPEGELS. ÖFAILURE INFORMATION FOR DIGITAL FIELD INSTRUMENTS WITH ANALOGUE OUTPUT: STANDARDIZATION OF THE SIGNAL LEVEL" AUTOMATISIERUNGSTECHNISCHE PRAXIS - ATP, OLDENBOURG INDUSTRIEVERLAG, MUNCHEN, DE, Bd. 36, Nr. 7, 1. Juli 1994 (1994-07-01), Seiten 30-32,34/35, XP000454543 ISSN: 0178-2320

## Beschreibung

Die Erfindung betrifft ein Verfahren zur Funktionsüberprüfung einer elektrischen Schaltung, die mindestens einen, einen integrierten Schaltkreis aufweisenden Sensorbaustein und eine diesem zugeordnete Diagnoseeinrichtung hat, wobei der Sensorbaustein mindestens einen mit der Diagnoseeinrichtung verbundenen Ausgangsanschluss und Stromversorgungsanschlüsse hat, an die über Zuleitungen eine Betriebsspannung angelegt wird.

Ein derartiges Verfahren ist z.B. aus EP 0 962 748 B1 , EP-1970720 A oder DE 100 37 495 A1 bekannt. Bei diesem Verfahren ist der Sensorbaustein als monolithisch integrierte Schaltung ausgebildet, die einen Sensor zur Messung eines Magnetfelds und einen Messverstärker aufweist. Der Sensor ist zur Ausgabe eines Ausgangsmesssignals über den Messverstärkers mit einem Ausgangsanschluss des Sensorbausteins verbunden. Außerdem hat der Sensorbaustein zwei Stromversorgungsanschlüsse, an die über Zuleitungen eine Betriebsspannung angelegt wird.

Über die vorhandenen Außenanschlüsse werden zusätzlich zu dem Messsignal innerhalb des Sensorbausteins zur Verfügung stehende Schaltungsmesswerte ausgegeben. Dabei werden die Schaltungsmesswerte als Modulationssignale dem Versorgungsstrom, der Versorgungsspannung und/oder dem Ausgangsmesssignal als Diagnosesignale überlagert. Entweder werden die internen Schaltungsmesswerte als analoge oder digitale Modulation und das Ausgangsmesssignal als digitaler Wert oder die internen Schaltungsmesswerte werden als digitale Modulation und das Ausgangsmessslgnal als analoger Wert ausgegeben. Am Ausgangsanschluss ist ein Controllerbaustein angeschlossen, der die Schaltungsmesswerte überprüft, um daraus eine Aussage über die Leistungsfähigkeit und die Funktionssituation des Bauelements abzuleiten. Das Verfahren hat sich in der Praxis vor allem deshalb bewährt, weil mit Hilfe des Verfahrens Verschleiß von mit dem Sensorbaustein zusammenwirkenden mechanischen Komponenten frühzeitig erkannt werden kann, so dass rechtzeitig vor einem Ausfall entsprechende Maßnahmen, wie z.B. ein Austausch der verschlissenen Komponenten, veranlasst werden können. Ein Nachteil des Verfahrens besteht jedoch noch darin, dass bei einem Defekt der elektrischen Schaltung nicht ohne Weiteres festgestellt werden kann, ob der Sensorbaustein oder die Zuleitungen schadhaft sind.

Es besteht deshalb die Aufgabe, ein Verfahren der eingangs genannten Art zu schaffen, das bei Auftreten eines Defekts an der elektrischen Schaltung, aufeinfache Weise eine Fehlerlokalisierung ermöglicht.

Erfindungsgemäß wird diese Aufgabe dadurch gelöst,
- dass der Sensorbaustein in einen Testmodus gebracht wird, in dem der Sensorbaustein ein vorbestimmtes, von einem konstanten Signalpegel abweichendes Kommunihationsprüfsignal an den Ausgangsanschluss ausgibt,
- dass das Kommunikationsprüfsignal von der Diagnoseeinrichtung eingelesen und zum Überprüfen der Funktion der Kommunkation mit dem Sensorbaustein mit einem vorbestimmten Toleranzbandverlaufverglichen wird,
   - dass bei funlstionsfähiger Kommunikation die Funktion des integrierten Schaltkreises getestet wird,
      - dass der Sensorbaustein bei nicht funktionsfähigem Schaltkreis
         - ein Fehlersignal über den Ausgangsanschluss an die Diagnoseeinrichtung übermittelt,
      - dass der Sensorbaustein bei funktionsfähigem Schaltkreis
         - ein sich vom Fehlersignal unterscheidendes Funktionssignal über den Ausgangsanschluss an die Diagnoseeinrichtung übermittelt, das von einer an den Stromversorgungsanschlüssen anliegenden Spannung abhängig ist, und
         - dass das von der Diagnoseeinrichtung empfangene Funktionssignal mit einem vorbestimmten Toleranzbereich verglichen wird und In Abhängigkeit vom Ergebnis dieses Vergleichs das Vorliegen oder Nicht vorliegen eines Fehlers in der Zuleitung festgestellt wird.

Bei dem Verfahren wird also zunächst die Kommunikation zwischen dem Sensorbaustein und der Diagnoseeinrichtung überprüft. Wenn diese Überprüfung ergibt, dass die Kommunikation fehlerfrei ist, sendet der Sensorbaustein als Statussignal entweder das Fehlersignal oder das Funktionssignal an die Diagnoseeinrichtung. Nachdem die Kommunikation zwischen dem Sensorbaustein und der Diagnoseeinrichtung zuvor überprüft wurde, wird davon ausgegangen, dass bei der Übertragung des Statussignals keine Fehler auftreten.

In vorteilhafter Weise ist es durch das Verfahren möglich, beim Auftreten eines Defekts an der elektrischen Schaltung auf einfache Weise festzustellen, ob der Sensorbaustein oder die Zuleitungen defekt sind. Ein Defekt In den Zuleitungen kann beispielsweise Vorliegen, wenn eine an der Zuleitung angeordnete elektrische Steckverbindung einen zu hohen Kontaktwiderstand aufweist oder wenn ein Kabelbruch und/oder eine mechanische Beschädigung an der Zuleitung aufgetreten ist. Nachdem der Defekt mit Hilfe des Verfahrens lokalisiert wurde, kann die elektrische Schaltung schnell und kostengünstig repariert werden, indem beispielsweise das entsprechende Bauteil erneuert wird. Wenn die elektrische Schaltung in ein Kraftfahrzeug eingebaut ist, kann der Fehler beispielsweise in der Diagnoseeinrichtung zwischengespeichert und beim nächsten Werkstattbesuch mit Hilfe eines entsprechenden Lesegeräts ausgelesen und zur Anzeige gebracht werden. Selbstverständlich ist es aber auch möglich, beispielsweise an der Armaturentafel oder einem Bordmonitor des Kraftfahrzeugs den Fehler anzuzeigen, um den Benutzer des Kraftfahrzeugs zu veranlassen, eine Werkstatt aufzusuchen. Mit Hilfe des Verfahrens kann auch auf einfache Weise überprüft werden, ob die Zuleitungen und der Sensorbaustein fehlerfrei funktionieren.

Bei einer vorteilhaften Ausgestaltung der Erfindung ist die Amplitude des Funktionssignals proportional zu der an den Stromversorgungsanschlüssen anliegenden Spannung oder einer Komponente dieser Spannung. Das Verfahren kann dann bei einem Sensorbaustein, der einen ratiometrischen Ausgangsanschluss aufweist, auf einfache Weise angewendet werden.

Zweckmäßigerweise wird der Ausgangsanschluss zum Ausgeben des Fehlersignals auf ein konstantes Potential gelegt, insbesondere auf Massepotential. Das Verfahren ist dann noch einfacher durchführbar.

Bei einer bevorzugten Ausführungsform der Erfindung wird der Sensorbaustein zwischen dem Testmodus und einem Betriebsmodus umgeschaltet, wobei im Betriebsmodus mindestens ein Messsignal erfasst und über den Ausgangsanschluss ausgeben wird. Der Ausgangsanschluss kann also außer zum Ausgeben des Fehler- bzw. Funktionssignals auch zum Ausgeben des Messsignals genutzt werden. Das Verfahren kann dann sogar bei Sensorbausteinen angewendet werden, die nur drei Außenanschlüsse aufweisen, nämlich den Ausgangsanschluss und zwei Stromversorgungsanschlüsse.

Das Umschalten zwischen dem Testmodus und dem Betriebsmodus kann in Abhängigkeit von einer externen elektrischen Spannung erfolgen, die an den Ausgangsanschluss angelegt wird und/oder in Abhängigkeit von einem elektrischen Strom erfolgt, der in den Ausgangsanschluss eingespeist wird. Auch durch diese Maßnahme kann die Anzahl der Außenanschlüsse des Sensorbausteins reduziert werden.

Es ist aber auch möglich, dass der Sensorbaustein durch das Anlegen der Betriebsspannung an die Stromversorgungsanschlüsse In den Testmodus gebracht wird. Das Verfahren wird dann beim Hochfahren des Sensorbausteins automatisch durchgeführt

Bei einer vorteilhaften Ausführungsform der Erfindung weist das Kommunikationsprüfsignal mindestens einen rampen-, treppen-, trapez- und/oder sägezahnförmigen Signalabschnitt auf. Das Verfahren kann dann auf einfache Weise bei Sensorbausteinen durchgeführt werden, deren Ausgangsanschluss über einen Digital-Analog-Konverter angesteuert wird. Dabei durchläuft das Kommunikationsprüfsignal vorzugsweise den gesamten Aussteuerungsbereich des Digital-AnalogKonverter, so dass bei der Überprüfung des Kommunikationsweges zwischen dem Sensorbaustein und der Diagnoseeinrichtung die Funktlonsähigkeit des Digital-Analog-Konverter mit überprüft wird.

Bei einer Weiterbildung der Erfindung werden mindestens zwei Sensorbausteinen unterschiedliche Kommunikationsprüfsignale zugeordnet, wobei eine der Anzahl der unterschiedlichen Kommunihationsprüfsignale entsprechende Anzahl unterschiedlicher Toleranzbandverläufe gespeichert wird, die jeweils einem Kommunlkationsprüfsignaf zugeordnet sind, wobei mindestens ein Sensorbaustein in den Testmodus gebracht wird und das ihm zugeordnete Kommunikationsprüfsignal an die Diagnoseeinrichtung überträgt, wobei das von der Diagnoseeinrichtung empfangene Kommunikationsprüfsignal mit den unterschiedlichen Toleranzbandverläufen verglichen wird, und wobei in Abhängigkeit vom Ergebnis dieser Vergleiche der Sensorbaustein, der das Kommunikationsprüfsignal ausgesendet hat, identifiziert wird. Dadurch ist es beispielsweise möglich, auf einfache Weise festzustellen, ob zwei oder mehr Sensorbausteine eines Kraftfahrzeugs beispielsweise bei einer Reparatur miteinander vertauscht oder an der falschen Stelle eingebaut wurden.

Vorzugsweise weist der integrierte Schaltkreis mindestens eine Hall-Platte mit zumindest einem Messstromeingang und wenigstens einem Hallspannungsausgang auf, der über eine Signalverarbeitungsstufe mit dem Ausgangsanschluss des Sensorbausteins verbunden ist, und wobei zum Erzeugen des Kommunikationsprüfsignals ein Testsignal an den Messstromeingang und/oder den Hollspannungsausgang der Hall-Platte angelegt und über die Signalverarbeitungsstufe zum Ausgangsanschluss geleitet wird. Dadurch kann mit Hilfe des Verfahrens der gesamte Signalweg zwischen der Hall-Platte und der Diagnoseeinrichtung und gegebenenfalls sogar die Hall-Platte selbst auf Funktionsfähigkeit getestet werden.

Nachfolgend ist ein Ausführungsbeispiel der Erfindung anhand der Zeichnung näher erläutert, Es zeigt
- Fig. 1: eine elektrische Schaltung, die einen Sensorbaustein, eine diesem zugeordnete Diagnoseeinrichtung und eine Stromversorgung aufweist,
- Fig. 2: ein Blockschaltbild des Sensorbausteins,
- Fig. 3: eine graphische Darstellung der Ausgangsspannung an einem Steuersignalausgang der Diagnoseeinrichtung, wobei auf der Abszisse die Zeit t und auf der Ordinate die Ausgangsspannung U aufgetragen ist,
- Fig. 4: eine graphische Darstellung der elektrischen Spannung an einem Ausgangsanschluss des Sensorbausteins, wenn ein in den Sensorbaustein integrierter Schaltkreis defekt ist, wobei auf der Abszisse die Zeit t und auf der Ordinate die Spannung U aufgetragen ist, und
- Fig. 5: eine Darstellung ähnlich Fig. 4, wobei jedoch der integrierte Schaltkreis funktionsfähig ist.

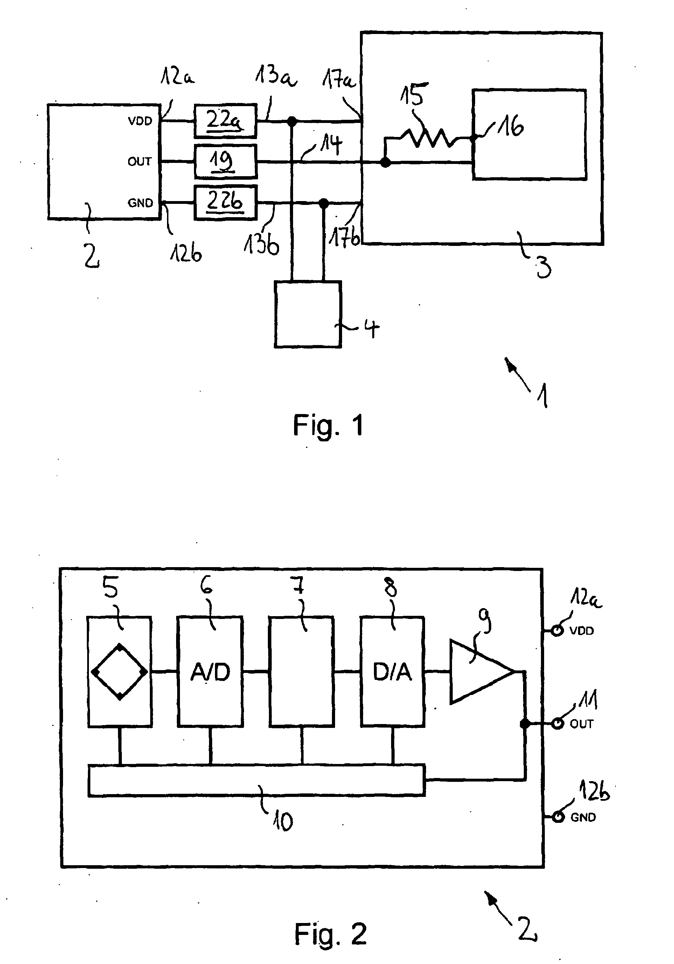

Eine in Fig. 1 im Ganzen mit 1 bezeichnete elektrischen Schaltung weist einen Sensorbaustein 2, eine Diagnoseeinrichtung 3 und eine Stromversorgung 4 dafür auf Der Sensorbaustein 2 ist als monolithisches Bauelement ausgebildet, das einen integrierten Schaltkreis beinhaltet, der einen Hall-Sensor 5, einen Analog-/Digitalkonverter 6, eine digitale Signalverarbeitungseinrichtung 7, einen Digital-Analogkonverter 8 eine analoge Verstärkerstufe 9 aufweist. Zur internen Überprüfung der Funktion dieser Komponenten ist in den Sensorbaustein 2 außerdem eine Testvorrichtung 10 integriert.

In Fig. 2 ist erkennbar, dass ein Messsignalausgang des Hall-Sensors 5 zur Ausgabe eines Magnetfeldmessslgnais über den Analog-/Digitalkonverter 6, die digitale Signalverarbeitungseinrichtung 7, den Digital-Analogkonverter 8 und die Verstärkerstufe 9 mit einem Ausgangsanschluss 11 des Sensorbausteins 2 verbunden ist. Ferner weist der Sensorbaustein 2 zwei Stromversorgungsanschlüsse 12a, 12b auf, die über Zuleitungen 13a, 13b an Betriebsspannungsanschlüssen der Stromversorgung 4 angeschlossen sind.

Der Ausgangsanschluss 11 des Sensorbausteins 2 ist über eine Signalleitung 14 mit der Diagnoseeinrichtung 3 verbunden. Außerdem ist die Signalleitung 14 über einen Widerstand an einem Steuersignalausgang 16 der Diagnoseeinrichtung 3 angeschlossen. Spannungsversorgungsanschlüsse 17a, 17b der Diagnoseeinrichtung 3 sind mit den Betriebsspannungsanschlüssen der Stromversorgung 4 verbunden.

Zur Überprüfung der Funktion des Sensorbausteins 2, der Zuleitungen 13a, 13b und der Signalleitung 14 wird zunächst eine Betriebsspannung an die Stromversorgungsanschlüsse 12a, 12b des Sensorbausteins 2 und die Spannungsversorgungsanschlüsse 17a, 17b der Diagnoseeinrichtung 3 angelegt.

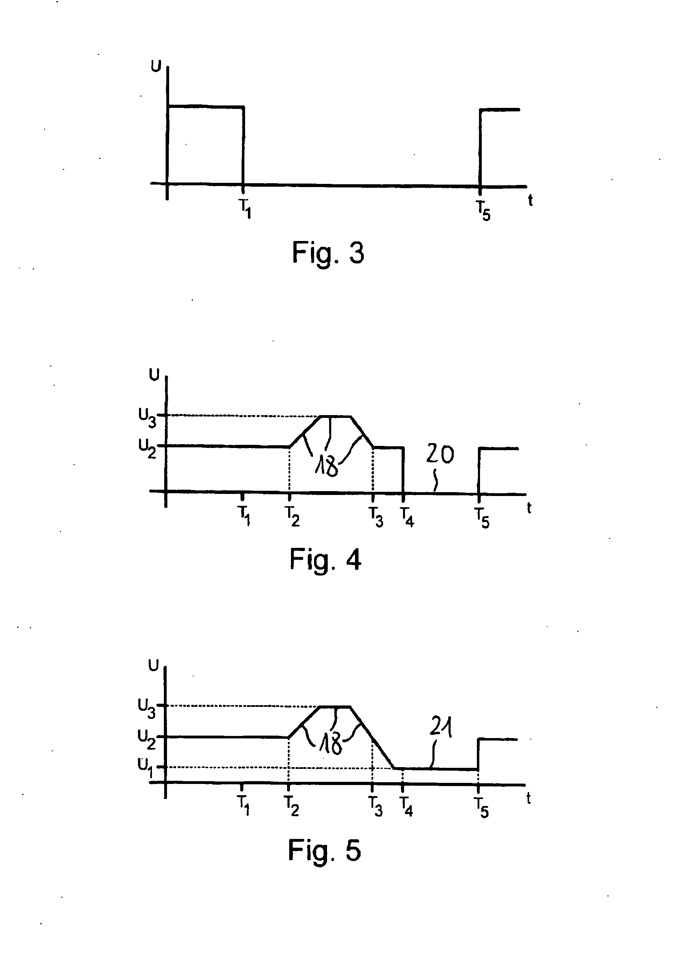

Dann wird der Sensorbaustein 2 in einen Testmodus gebracht, indem die Diagnoseeinrichtung 3 zum Zeitpunkt T₁ an den Steuersignalausgang 16 ein erstes Steuersignal ausgibt (Fig. 3). Die über den Ausgangsanschluss 11 und den Widerstand 15 mit dem Steuersignalausgang 16 verbundene Testvorrichtung 10 detektiert das Steuersignal und legt an einen Eingang des Analog-/Digitalkonverters 6 ein Testsignal an, das derart gewählt ist, dass nach einer Verzögerungszeit am Ausgangsanschluss 11 des Sensorbausteins 2 zwischen den Zeitpunkten T₂ und T₃ ein etwa trapezförmiges Kommunikationsprüfsignal 18 ausgegeben wird (Fig. 4, 5).

Während der Ausgabe des Kommunikationsprüfsignals 18 durchlaufen der Analog-/Digitalkonverter 6 und der Digital-Analogkonverter 8 zumindest einen Teil ihres Aussteuerungsberelchs. Zunächst steigt der Signalpegel des Kommunikationsprüfsignals 18, ausgehend von einem Wert U₂ etwa rampenförmig an, bis der Signalpegel einen Wert U₃ erreicht. Danach bleibt der Signalpegel zunächst konstant, um anschließend etwa rampenförmig auf den Wert U₂ abzufallen. In Fig. 4 ist erkennbar, dass das Potential des Kommunikationsprüfsignals 18 oberhalb der Ausgangsspannung U₂ liegt, der an dem Ausgangsanschluss 11 anliegt, wenn der Testmodus nicht aktiviert ist.

Das Kommunikationsprüfsignal 18 wird von der Diagnoseeinrichtung 3 eingelesen und zum Überprüfen der Funktion der Kommunikation mit dem Sensorbaustein 2 mit einem vorbestimmten, in der Zeichnung nicht näher dargestellten Toleranzbandverlauf verglichen. Bei Übereinstimmung mit dem Toleranzbandverlauf wird davon ausgegangen, dass über die Signalleitung 14 eine fehlerfreie Kommunikation zwischen dem Sensorbaustein 2 und der Diagnoseeinrichtung 3 möglich ist.

Wenn das von der Diagnoseeinrichtung 3 empfangene Kommunikationsprüfsignal 18 nicht mit dem Toleranzbandverlauf übereinstimmt, wird angenommen, dass die Kommunikation mit dem Sensorbaustein 2 gestört oder nicht möglich ist. Eine solche Störung kann beispielsweise durch einen parasitären ersten Widerstand 19 in der Signalleitung 14 verursacht sein (Fig. 1).

Nun wird mit Hilfe der Testvorrichtung 10 in an sich bekannter Weise die Funktion des integrierten Schaltkreises getestet. Dazu werden innerhalb des Sensorbausteins zur Verfügung stehende Signale mit Sollwerten oder Sollwertbereichen verglichen und bei Übereinstimmung wird davon ausgegangen, dass der integrierte Schaltkreis funktionsfähig ist. Wenn mindestens ein Signal außerhalb einer für dieses Signal zulässigen Toleranz liegt, wird angenommen, dass die integrierte Schaltkreis defekt ist.

In dem zuletzt genannten Fall übermittelt der Sensorbaustein 2 zwischen den Zeitpunkten T₄ und T₅ ein Fehlersignal 20 über den Ausgangsanschluss 11 an die Diagnoseeinrichtung 3. Wie in Fig. 4 erkennbar ist, entspricht der Signalpegel des Fehlersignals 20 dem Massepotenflal. In Fig. 4 ist außerdem erkennbar, dass nach der Übertragung des Kommunlkationsprüfsignals 18 zunächst eine vorbestimmte Zeitdauer [T₃ .. T₄] abgewartet wird, bevor das Fehlersignal 20 an den Ausgangsanschluss 11 angelegt wird.

Wenn der Test des integrierten Schaltkreises ergibt, dass der Schaltkreis funktionsfähig ist, gibt die Testvorrichtung 10 ab dem Zeitpunkt T₄ ein sich vom Fehlersignal 20 unterscheidendes Funktionssignal 21 an den Ausgangsanschluss 11 aus (Fig. 5). Der Signalpegel des Funktionssignals 21 ist von der an den Stromversorgungsanschlüssen 12a, 12b des Sensorbausteins 2 anliegenden elektrischen Spannung abhängig. Dies wird dadurch ermöglicht, dass die Verstärkerstufe 9 ratiometrisch ausgestaltet ist.

In Fig. 5 ist erkennbar, dass nach Beendigung des Kommunikationsprüfsignals 18 ab dem Zeitpunkt T₃ die rampenförmige Abnahme des Signalpegels am Ausgangsanschluss solange fortgesetzt wird, bis der Signalpegel den für das Funktionssignal vorgesehenen Wert erreicht. Dieser wird dann im Zeitintervall [T₄ .. T₅] konstant gehalten.

Das im Zeitintervall [T₄ .. T₅] von der Diagnoseeinrichtung 3 empfangene Signal wird mit einem in der Diagnoseeinrichtung 3 gespeicherten Toleranzbereich sowie einem dem Fehlersignal 20 zugeordneten Toleranzband verglichen. Der Toleranzbereich ist so gewählt, dass er das Toleranzband nicht enthält. Liegt das von der Diagnoseeinrichtung 3 empfangene Signal außerhalb des Toleranzbereichs und außerhalb des Toleranzbands, wird davon ausgegangen, dass ein Fehler in den Zuleitungen 13a, 13b vorliegt. Ein solcher Fehler kann beispielsweise durch einen parasitären zweiten Widerstand 22a, 22b in den Zuleitungen 13a, 13b verursacht sein.

Die die Diagnoseeinrichtung 3 veranlasst dann geeignete Maßnahmen, um die Auswirkungen des Fehlers zu begrenzen. So kann beispielsweise ein Notbetrieb aktiviert werden, in dem anstelle des Messsignals des Sensorbausteins 2 ein geeignetes Ersatzsignal bereitgestellt und verwendet wird. Beim Auftreten des Fehlers wird eine erste Fehlermeldung angezeigt und/oder im Datenspeicher abgelegt.

Ergibt der Vergleich, dass das im Zeitintervall [T₄ .. T₅] von der Diagnoseeinrichtung 3 empfangene Signal innerhalb des dem Fehlersignal 20 zugeordneten Toleranzbands liegt, wird davon ausgegangen, dass die integrierte Schaltung defekt ist. Auch in diesem Fall veranlasst die Diagnoseeinrichtung 3 geeignete Maßnahmen, um die Auswirkungen des Fehlers zu begrenzen. Beim Auftreten des Fehlers wird eine zweite Fehlermeldung angezeigt und/oder im Datenspeicher abgelegt.

Ergibt der Vergleich, dass das im Zeitintervall [T₄ .. T₅] von der Diagnoseeinrichtung 3 empfangene Signal innerhalb des Toleranzbereichs liegt, wird davon ausgegangen, dass die integrierte Schaltung und die Zuleitungen 1 3a, 1 3b fehlerfrei sind. Die Diagnoseeinrichtung 3 legt dann ab dem Zeitpunkt T₅ ein zweites Steuersignal an die Signalleitung an, das vom Sensorbaustein 2 empfangen wird, woraufhin dieser vom Testmodus in einen Betriebsmodus umgeschaltet wird.

Im Betriebsmodus gibt der Sensorbaustein 2 in an sich bekannter Weise das mit Hilfe des Hall-Sensors gemessene und mittels der den Analog-/Digitalkonverters 6, die digitalen Signalverarbeitungseinrichtung 7, den Digital-Analogkonverter 8 und die analoge Verstärkerstufe 9 aufweisenden Signalverarbeitungsstufe verarbeitete Magnetfeldmesssignal an den Ausgangsanschluss 11 aus. Das Magnetfeldmesssignal wird über die Signalleitung 14 zu der Diagnoseeinrichtung 3 übertragen und dort ausgewertet.

## Patentansprüche

1. Verfahren zur Funktionsüberprüfung einer elektrischen Schaltung, die mindestens einen, einen integrierten Schaltkreis aufwelsenden Sensorbaustein (2) und eine diesem zugeordnete Diagnoseeinrichtung (3) hat, wobei der Sensorbaustein (2) mindestens einen mit der Diagnoseeinrichtung (3) verbundenen Ausgangsanschluss (11) und Stromversorgungsanschlüsse (12a, 12b) hat, an die über Zuleitungen (13a, 1 3b) eine Betriebsspannung angelegt wird,
- wobei der Sensorbaustein (2) in einen Testmodus gebracht wird, in dem der Sensorbaustein (2) ein vorbestimmtes, von einem konstanten Signalpegel abweichendes Kommunlkationsprüfsignal (18) an den Ausgangsanschluss (11) ausgibt,
- wobei das Kommunlkationsprüfsignal (18) von der Diagnoseeinrichtung (3) eingelesen und zum Überprüfen der Funktion der Kommunikation mit dem Sensorbaustein (2) einem vorbestimmten Toleranzbandvedauf verglichen wird,
- wobei bei funktionsfähiger Kommunikation die Funktion des integrierten Schaltkreises getestet wird,
- wobei der Sensorbaustein (2) bel nicht funktionsfähigem Schaltkreis
- ein Fehlersignal (20) über den Ausgangsanschluss (11) an die Diagnoseeinrichtung (3) übermittelt,
- wobei der Sensorbaustein (2) bei funktionsfähigem Schaltkreis
- ein sich vom Fehlersignal (20) unterscheidendes Funktionssignal (21) über den Ausgangsanschluss (11) an die Diagnoseeinrichtung (3) übermittelt, das von einer an den Stromversorgungsanschlüssen (12a, 12b) anliegenden Spannung abhängig ist, und
- wobei das von der Diagnoseeinrichtung (3) empfangene Funktionssignal (21) mit einem vorbestimmten Toleranzbereich verglichen wird und in Abhängigkeit vom Ergebnis dieses Vergleichs das Vorliegen oder Nichtvohiegen eines Fehlers in der Zuleitung (13a, 13b) festgestellt wird.

2. Verfahren noch Anspruch 1, **dadurch gekennzeichnet, dass** die Amplitude des Funkfionssignals (21) proportional zu der an den Stromversorgungsanschlüssen (12a, 12b) anliegenden Spannung oder einer Komponente dieser Spannung ist.

3. Verfahren nach Anspruch 1 oder 2, **dadurch gekennzeichnet, dass** der Ausgangsanschluss (11) zum Ausgeben des Fehlersignals (20) auf ein konstantes Potential gelegt wird, insbesondere auf Massepotential.

4. Verfahren nach einem der Ansprüche 1 bis 3, **dadurch gekennzeichnet, dass** der Sensorbaustein (2) zwischen dem Testmodus und einem Betriebsmodus umgeschattet wird, und dass im Betriebsmodus mindestens ein Messsignal erfasst und über den Ausgangsanschluss (11) ausgeben wird.

5. Verfahren nach einem der Ansprüche 1 bis 4, **dadurch gekennzeichnet, dass** das Umschalten zwischen dem Testmodus und dem Betriebsmodus in Abhängigkeit von einer externen elektrischen Spannung erfolgt, die an den Ausgangsanschluss (11) angelegt wird und/oder in Abhängigkeit von einem elektrischen Strom erfolgt, der in den Ausgangsanschluss (11) eingespeist wird.

6. Verfahren nach einem der Ansprüche 1 bis 5, **dadurch gekennzeichnet, dass** der Sensorbaustein (2) durch das Anlegen der Betriebsspannung an die Stromversorgungsanschlüsse (12a, 12b) in den Testmodus gebracht wird.

7. Verfahren nach einem der Ansprüche 1 bis 6, **dadurch gekennzeichnet, dass** das Kommunikationsprüfsignal (18) mindestens einen rampen-, treppen-, trapez- und/oder sägezahnförmigen Signalabschnitt aufweist.

8. Verfahren nach einem der Ansprüche 1 bis 7, **dadurch gekennzeichnet, dass** mindestens zwei Sensorbausteinen (2) unterschiedliche Kommunikationsprüfsignale (18) zugeordnet werden, dass eine der Anzahl der unterschiedlichen Kommunikatlonsprüfsignale (18) entsprechende Anzahl unterschiedlicher Toleranzbandverläufe gespeichert wird, die jeweils einem Kommunikationsprüfsignal (18) zugeordnet sind, dass mindestens ein Sensorbausteln (2) in den Testmodus gebracht wird und das ihm zugeordnete Kommunikationsprüfsignal (18) an die Diagnoseeinrichtung überträgt, dass das von der Diagnoseeinrichtung (3) empfangene Kommunikationsprüfsignal (18) mit den unterschiedlichen Toleranzbandverläufen verglichen wird, und in Abhängigkeit vom Ergebnis dieser Vergleiche der Sensorbaustein (2), der das Kommunlkationsprüfsignal (18) ausgesendet hat, identifiziert wird.

9. Verfahren nach einem der Ansprüche 1 bis 8, **dadurch gekennzeichnet, dass** der integrierte Schaltkreis mindestens eine Hall-Platte mit zumindest einem Messstromeingang und wenigstens einem Hallspannungsausgang aufweist, der über eine Signalverarbeitungsstufe mit dem Ausgangsanschluss (11) des Sensorbausteins verbunden ist, und dass zum Erzeugen des Kommunikationsprüfsignals (18) ein Testsignal an den Messstromeingang und/oder den Hallspannungsausgang der Hall-Platte angelegt und über die Signalverarbeitungsstufe zum Ausgangsanschluss (11) geleitet wird.

## Claims

1. Method for functional checking of an electric circuit, which has at least one sensor module (2), which comprises an integrated circuit, and a diagnostic device (3) associated therewith, wherein the sensor module (2) has at least one output connection (11), which is connected with the diagnostic device (3), and power supply connections (12a, 12b) to which an operating voltage is applied by way of feed lines (13a, 13b),
- wherein the sensor module (2) is brought into a test mode in which the sensor module (2) delivers to the output connection (11) a predetermined communications test signal (18) departing from a constant signal level,
- wherein the communications test signal (18) is read in by the diagnostic device (3) and for checking the function of the communication with the sensor module (2) is compared with a predetermined tolerance band plot,
- wherein in the case of a functionally capable communication the function of the integrated circuit is tested
- wherein the sensor module (2) in the case of a non-functionally-capable circuit
- transmits a fault signal (20) by way of the output connection (11) to the diagnostic device (3),
- wherein the sensor module (2) in the case of a functionally capable circuit
- communicates a function signal (21), which differs from the fault signal (20), by way of the output connection (11) to the diagnostic device (3), which function signal is dependent on a voltage lying at the current supply connections (12a, 12b), and
- wherein the function signal (21) received by the diagnostic device (3) is compared with a predetermined tolerance range and the presence or non-presence of a fault in the feed line (13a, 13b) is ascertained in dependence on the result of this comparison.

2. Method according to claim 1, **characterised in that** the amplitude of the function signal (21) is proportional to the voltage lying at the current supply connections (12a, 12b) or a component of this voltage.

3. Method according to claim 1 or 2, **characterised in that** the output connection (11) is, for issue of the fault signal (20), placed at a constant potential, particularly to ground potential.

4. Method according to any one of claims 1 to 3, **characterised in that** the sensor module (2) is switchable over between the test mode and an operating mode and that in the operating mode at least one measurement signal is detected and output by way of the output connection (11).

5. Method according to any one of claims 1 to 4, **characterised in that** the switching-over between the test mode and the operating mode is carried out in dependence on an external electrical voltage, which is applied to the output connection (11), and/or is carried out in dependence on an electrical current, which is supplied to the output connection (11).

6. Method according to any one of claims 1 to 5, **characterised in that** the sensor module (2) is brought into the test mode by the application of the operating voltage to the current supply connections (12a, 12b).

7. Method according to any one of claims 1 to 6, **characterised in that** the communications test signal (18) has at least one ramp-shaped, stair-shaped, trapezium-shaped and/or sawtooth-shaped signal section.

8. Method according to any one of claims 1 to 7, **characterised in that** different communications test signals (18) are assigned to at least two sensor modules (2), that a number, which corresponds with the number of the different communications test signals (18), of different tolerance band plots is stored, which are each associated with respective communications test signal (18), that at least one sensor module (2) is brought into the test mode and the communications test signal (18) associated therewith is transmitted to the diagnostic device, that the communications test signal (18) received by the diagnostic device (3) is compared with the difference tolerance band plots, and the sensor module (2) which has transmitted the communications test signal (18) is identified in dependence on the result of this comparison.

9. Method according to any one of claims 1 to 8, **characterised in that** the integrated circuit comprises at least one Hall plate with at least one measurement current input and at least one Hall voltage output, which is connected by way of a signal processing stage with the output connection (11) of the sensor module, and that for generating the communications test signal (18) a test signal is applied to the measurement current input and/or the Hall voltage output of the Hall plate and conducted by way of the signal processing stage to the output connection (11).

## Revendications

1. Procédé de contrôle du fonctionnement d'un circuit électrique, qui comprend au moins un élément de détecteur (2) présentant un circuit de commutation intégré et un dispositif de diagnostic (3) associé à celui-ci, dans lequel l'élément de détecteur (2) comporte au moins une borne de sortie (11) reliée au dispositif de diagnostic (3) et des bornes d'alimentation électrique (12a, 12b), auxquelles une tension de service est appliquée par des lignes d'alimentation (13a, 13b),
- dans lequel l'élément de détecteur (2) est placé dans un mode de test, dans lequel l'élément de détecteur (2) envoie à la borne de sortie (11) un signal de contrôle de communication prédéterminé (18) s'écartant d'un niveau de signal constant,
- dans lequel on lit le signal de contrôle de communication (18) au moyen du dispositif de diagnostic (3) et on le compare à un tracé de bande de tolérance prédéterminé pour contrôler le fonctionnement de la communication avec l'élément de détecteur (2),
- dans lequel, lorsque la communication est apte à fonctionner, on teste le fonctionnement du circuit de commutation intégré
- dans lequel, lorsque le circuit de commutation n'est pas apte à fonctionner, l'élément de détecteur (2)
- transmet un signal d'erreur (20) au dispositif de diagnostic (3) via la borne de sortie (11),
- dans lequel, lorsque le circuit de commutation est apte à fonctionner, l'élément de détecteur (2)
- transmet au dispositif de diagnostic (3), via la borne de sortie (11), un signal de fonctionnement (21) différent du signal d'erreur (20), qui dépend d'une tension appliquée aux bornes d'alimentation électrique (12a, 12b), et
- dans lequel on compare le signal de fonctionnement (21) reçu par le dispositif de diagnostic (3) à une plage de tolérance prédéterminée et on constate, en fonction du résultat de cette comparaison, la présence ou l'absence d'un défaut dans la ligne d'alimentation (13a, 13b).

2. Procédé selon la revendication 1, **caractérisé en ce que** l'amplitude du signal de fonctionnement (21) est proportionnelle à la tension appliquée aux bornes d'alimentation électrique (12a, 12b) ou à une composante de cette tension.

3. Procédé selon la revendication 1 ou 2, **caractérisé en ce que** l'on place la borne de sortie (11) à un potentiel constant, en particulier au potentiel de la masse, pour produire le signal d'erreur (20).

4. Procédé selon l'une quelconque des revendications 1 à 3, **caractérisé en ce que** l'on inverse l'élément de détecteur (2) entre le mode de test et un mode de fonctionnement, et **en ce que** l'on détecte au moins un signal de mesure dans le mode de fonctionnement et on le transmet via la borne de sortie (11).

5. Procédé selon l'une quelconque des revendications 1 à 4, **caractérisé en ce que** l'on effectue l'inversion entre le mode de test et le mode de fonctionnement en fonction d'une tension électrique externe, qui est appliquée à la borne de sortie (11) et/ou elle est effectuée en fonction d'un courant électrique, qui est introduit à la borne de sortie (11).

6. Procédé selon l'une quelconque des revendications 1 à 5, **caractérisé en ce que** l'on amène l'élément de détecteur (2) dans le mode de test par l'application de la tension de service aux bornes d'alimentation électrique (12a, 12b).

7. Procédé selon l'une quelconque des revendications 1 à 6, **caractérisé en ce que** le signal de contrôle de communication (18) présente au moins une partie de signal en forme de rampe, d'escalier, de trapèze et/ou de dents de scie.

8. Procédé selon l'une quelconque des revendications 1 à 7, **caractérisé en ce que** des signaux de contrôle de communication différents (18) sont associés à au moins deux éléments de détecteur (2), **en ce que** l'on mémorise un nombre de tracés de bande de tolérance différents correspondant au nombre des signaux de contrôle de communication différents (18), tracés qui sont respectivement associés à un signal de contrôle de communication (18), en ce l'on place au moins un élément de détecteur (2) dans le mode de test et on transmet le signal de contrôle de communication (18) associé à celui-ci au dispositif de diagnostic, **en ce que** l'on compare le signal de contrôle de communication (18) reçu par le dispositif de diagnostic (3) aux différents tracés de bande de tolérance, et on identifie, en fonction du résultat de ces comparaisons, l'élément de détecteur (2) qui a émis le signal de contrôle de communication (18).

9. Procédé selon l'une quelconque des revendications 1 à 8, **caractérisé en ce que** le circuit de commutation intégré comprend au moins une plaque de Hall avec au moins une entrée de courant de mesure et au moins une sortie de tension de Hall, qui est reliée à la borne de sortie (11) de l'élément de détecteur via un étage de traitement de signaux, et **en ce que**, pour produire le signal de contrôle de communication (18), on applique un signal de test à l'entrée de courant de mesure et/ou à la sortie de tension de Hall de la plaque de Hall, et on le conduit à la borne de sortie (11) via l'étage de traitement de signaux.
